# EUROPÄISCHE PATENTSCHRIFT

(11) **EP 1 397 827 B1**
(45) Veröffentlichungstag und Bekanntmachung des Hinweises auf die Patenterteilung: **02.04.2008**
(21) Anmeldenummer: 02740493.8
(22) Anmeldetag: 22.04.2002
(51) Int. Cl.: H01L 21/00, C23C 16/458, C30B 25/12

(54) **AUS EINEM TRAGKÖRPER UND DARAUF GASGELAGERTEN UND DREHANGETRIEBENEN SUBSTRATHALTER BESTEHENDE ANORDNUNG**
ARRANGEMENT COMPRISING A SUPPORT BODY WITH A SUBSTRATE HOLDER MOUNTED THEREON ON A GAS BEARING WITH ROTATING DRIVE
ENSEMBLE CONSTITUE D'UN CORPS SUPPORT ET D'UN PORTE-SUBSTRAT MONTE SUR CE DERNIER DANS UN COUSSINET GAZEUX ET ENTRAINE EN ROTATION

(30) Priorität: 29.05.2001 DE 10126274; 19.07.2001 DE 10135151
(43) Veröffentlichungstag der Anmeldung: 17.03.2004
(73) Patentinhaber: Aixtron AG, 52072 Aachen (DE)
(72) Erfinder: STRAUCH, Gerd, 52072 Aachen (DE)
(74) Vertreter: Grundmann, Dirk
(86) Internationale Anmeldenummer: PCT/EP2002/004406
(87) Internationale Veröffentlichungsnummer: WO 2002/097867

(56) Entgegenhaltungen:
- US-A- 4 860 687
- US-A- 5 840 125
- PATENT ABSTRACTS OF JAPAN vol. 012, no. 020 (E-575), 21. Januar 1988 (1988-01-21) & JP 62 177912 A (HITACHI LTD), 4. August 1987 (1987-08-04)

## Beschreibung

Die Erfindung betrifft eine aus einem Tragkörper und darauf gasgelagerten und drehangetriebenen Substrathalter bestehende Anordnung, wobei die Gaslagerung und der Drehantrieb mittels in die Trennfuge zwischen Tragkörper und Substrat aus Düsen einströmendes Gas gebildet sind.

Eine derartige Anordnung ist aus dem US-Patent 4,860,687 vorbekannt. Dort besteht der Tragkörper aus einer Platte, aus welcher ein Zentrierstift ragt. Um den Zentrierstift sind spiralartig, Nuten angeordnet, in welche Düsen münden, durch welche ein Gas in die bogenförmigen Nuten eintritt. Auf dem Zapfen liegt eine kreisscheibenförmige Platte, die von den aus den Düsen austretenden Gasströmen gasgelagert ist. Die in die Bogen-Nuten umgelenkten Gasströme nehmen die Platte in Strömungsrichtung mit, so dass ein viskoser Drehantrieb erzeugt wird.

Der Substrathalter und die darauf aufliegende Platte werden von unten bspw. mittels Hochfrequenz beheizt.

Der Erfindung liegt die Aufgabe zugrunde, eine Vorrichtung anzugeben, mittels derer eine schnelle Wärmebehandlung eines auf einem Substrathalter aufliegenden Substrates möglich ist.

Diese Aufgabe ist zunächst und im Wesentlichen vom Gegenstand des Anspruches 1 gelöst, in welchem darauf abgestellt ist, dass der Tragkörper und der Substrathalter als Ringe ausgebildet sind. Die in den weiteren Ansprüchen angegebenen Gegenstände betreffen sowohl vorteilhafte Weiterbildungen zum Gegenstand des Anspruches 1 als auch gleichzeitig davon und von der oben genannten Aufgabenstellung unabhängige, eigenständige technische Lösungsvorschläge. Es wird dabei darauf abgestellt, dass die Ringe selbstzentrierend aufeinanderliegen. Der eine Ring kann hierzu einen in eine Ringaussparung des anderen Ringes eingreifenden Ringwulst aufweisen. Der Ringwulst kann als Keil ausgebildet sein, der in einer entsprechende Gegenkeilfläche des anderen Ringes eingreift. Das Substrat liegt jetzt nur mit seinem Rand auf dem Rand des drehangetriebenen Ringes. Es sind keine weiteren Zentrier- oder Lagerhilfsmittel erforderlich. Insbesondere ist der Ort, an welchem sich die gedachte Drehachse befindet frei. Dies bedeutet, dass das auf dem rotierenden Ring aufliegende Substrat von unten durch den Ring bspw. mittels infraroter Strahlung beheizt werden kann. Gleichzeitig kann von oben her eine Bestrahlung des Substrates erfolgen, so dass die Homogenität der Wärmebeaufschlagung verbessert ist. Die Düsen münden wie beim Stand der Technik an sich bekannt in Nuten, insbesondere Bogennuten. Anders als beim Stand der Technik sind die Bogennuten jedoch auch so gestaltet, dass sich entgegengesetzte Strömungen ausbilden können. Dadurch kann der drehangetriebene Ring in unterschiedliche Drehrichtungen ge- ... dreht werden. Er kann aber auch durch Gegenstrom gebremst werden. Die Bremsung erfolgt dann ausschließlich über das Gaspolster, welches thermisch-isolierend zwischen den beiden Ringen wirkt. Dies führt zu einem thermisch isolierten Stillstand des drehantreibbaren Ringes. Die Abbremsung in den Stillstand erfolgt ebenso wie der Drehantrieb partikelfrei, das heißt ohne eine Festkörperreibung. Die Ringe können aus Quarz oder aus Keramik bestehen. Insbesondere der untere Ring besteht aus diesem Material. Die erfindungsgemäße Anordnung ist insbesondere Teil einer Vorrichtung zum thermischen . Behandeln von Halbleiterscheiben während des Produktionsprozesses für Halbleiterbauelemente. Insbesondere dient die Anordnung dazu, ein kreisscheibenförmiges Substrat randunterfasst zu lagern, die Lagerung soll dabei möglichst thermisch-isoliert vom restlichen Teil der Vorrichtung erfolgen. Erfindungsgemäß lassen sich diese Vorgaben damit erfüllen. Zudem ist durch die Rotation sichergestellt, dass die thermische Behandlung rotationssymmetrisch homogen erfolgt. Damit ist auch bei einer großen Skalierung eine große Homogenität gewährleistet. In einer Weiterbildung der Erfindung kann vorgesehen sein, dass der Rand des Substrates lediglich auf nadelförmigen Spitzen des drehangetriebenen Ringes aufliegt. Damit ist die Wärmeabfuhr oder die Wärmezufuhr vom oder zum Substrat im Wege der Wärmeleitung durch Oberflächenkontakt minimiert. Auch dies fördert die Homogenität der thermischen Behandlung.

Ein Ausführungsbeispiel der Erfindung wird nachfolgend, anhand beigefügter Zeichnungen erläutert. Es zeigen:
- Fig. 1: die Anordnung in der Draufsicht,
- Fig. 2: einen Schnitt gemäß der Linie II-II in Fig. 1,
- Fig. 3: eine Ausschnittsvergrößerung des statischen Ringes im Bereich III in Fig. 1,
- Fig. 4: eine Darstellung gemäß Fig. 2 einer zweiten Ausführungsform,
- Fig. 5: eine Darstellung gemäß Fig. 2 einer dritten Ausführungsform,
- Fig. 6: eine Draufsicht auf den drehangetriebenen Ring ohne daraufliegendes Substrat eines weiteren Ausführungsbeispiels und
- Fig. 7: einen Schnitt gemäß der Linie VII-VII in Fig. 6.

Die Anordnung, die in den Figuren schematisch dargestellt ist, ist Teil einer Vorrichtung zum thermischen Behandeln von Halbleiter-Wafern. Diese Behandlung kann unter einer Inertgasatmosphäre stattfinden. Dazu wird der Wafer 3, der als Substrat zu bezeichnen ist, von oben mittels Lampen beheizt. Das von den Lampen ausgehende infrarote Licht 6. beheizt die Substratoberseite. Von unten wird das Substrat ebenfalls mittels Lampen beheizt. Das von diesen Lampen ausgehende infrarote Licht 5 beheizt das Substrat 3 von unten.

Die Anordnung besitzt einen stationären Ring 1, der aus Quarz oder aus Keramik gefertigt werden kann. Auf dem stationären Ring 1 liegt ein drehangetriebener Ring 2. Beide Ringe sind etwa gleich groß.

Auf dem drehangetriebenen Ring 2 liegt mit seinem Rand das Substrat 3 auf Das Substrat 3 liegt demzufolge hohl auf dem Substrathalter 2.

Die Trennebene, die sich zwischen dem stationären Ring 1 und dem rotierenden Ring 2 befindet bildet einen Ringwulst aus. Dieser Ringwulst ist bevorzugt dem stationären Ring 1 zugeordnet. Der Ringwulst ragt in eine entsprechend negative Ringaussparung des rotierenden Ringes 2 ein, so dass eine formschlüssige Zentrierung der beiden Ringe aufeinander gewährleistet ist.

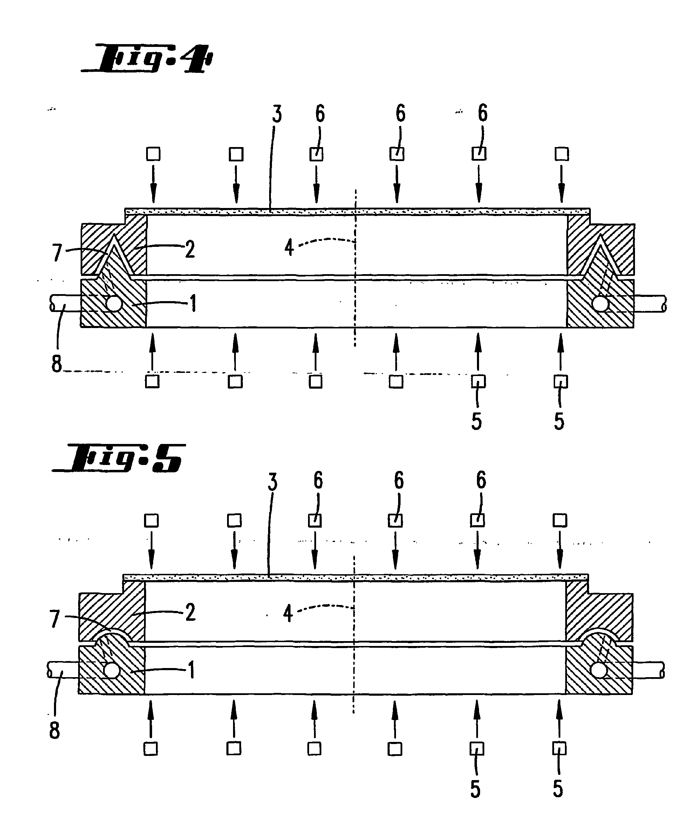

Bei dem in Fig. 4 dargestellten Ausführungsbeispiel besitzt der Ringwulst eine Dachform. Die entsprechende Nut besitzt eine Kerbfozm.

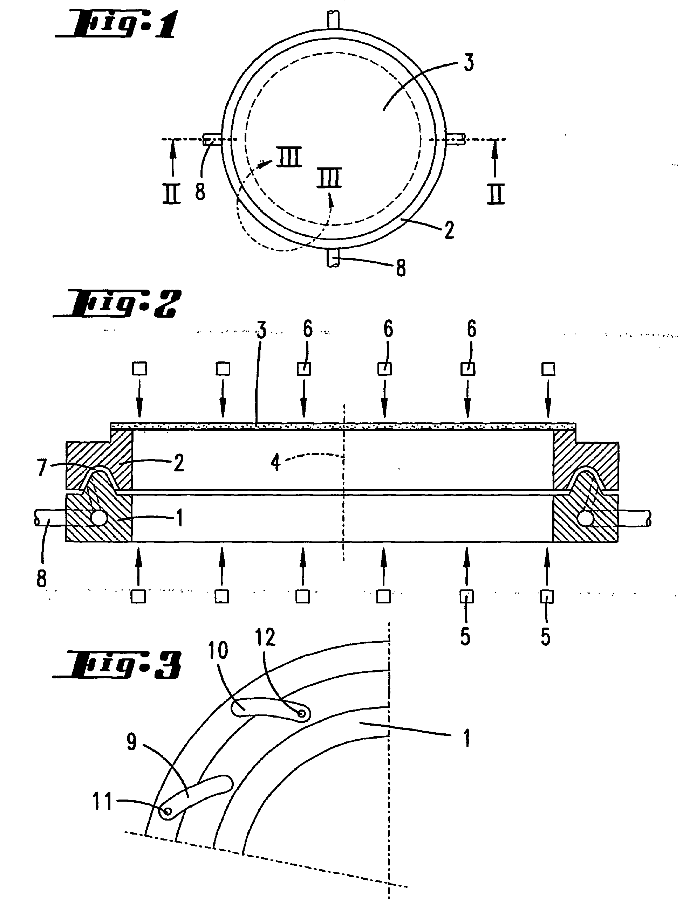

Bei dem in Fig. 5 dargestellten Ausführungsbeispiel besitzt der Wulst wie auch bei dem in Fig. 2 dargestellten Ausführungsbeispiel im Querschnitt eine Bogenform. Wegen der thermischen Expansion des rotierenden Ringes 2 ist die dem Wulst zugeordnete Nut des Ringes 2 radial einwärts versetzt angeordnet.

In dem stationären Ring 1 befinden sich Gaszuleitungen 8, die in Düsen 11 bzw. 12 münden. Die Düsen 11 bzw. 12 münden im Bereich der Trennebene zwischen den beiden Ringen 1, 2. Zufolge des aus den Düsen 11, 12 austretenden Gases bildet sich zwischen den beiden Ringen 1, 2 ein Spalt 7 aus. Dieser Spalt 7 bildet ein Gaslager für den rotierenden Ring 1.

Wie insbesondere aus der Fig. 3 zu entnehmen ist, münden die Düsen 11, 12 in Bogennuten 9, 10. Diese Bogennuten 9, 10 geben dem aus den Düsen 11, 12 mündenden Gas eine Vorzugs- Strömungsrichtung in Richtung des Nutenverlaufes. Die beiden Strömungsrichtungen in den in Fig. 3. dargestellte Nuten 10 und 11 sind entgegengesetzt gerichtet. Zufolge einer viskosen Ankopplung des Gasstroms, welcher durch die Nuten 10, 11 strömt, wird der rotierende Ring 2 drehmitgenommen.

Es sind jeweils eine Vielzahl von Bogennuten 9, 10 vorgesehen, wobei sich die Nuten 9, 10 in Ringumfassungsrichtung gleichverteilt abwechseln. Fließt nur durch die Nuten 9 ein Gasstrom, so wird der rotierende Ring im Uhrzeigersinn mitgeschleppt. Fließt dagegen nur durch die Bogennuten 10 ein Gasstrom, so wird der rotierende Ring 2 im Gegenuhrzeigersinn mitgenommen. Durch Wechsel der Strömungsrichtung kann ein in Drehung versetzter Ring 1 gebremst werden. Wird durch beide Düsen 11, 12 ein Gasstrom in die jeweiligen Nuten 9, 10 eingeleitet, so heben sich die beiden Drehmomente auf. Dadurch ist das Gaslager auch ohne Drehung betreibbar.

Der Drehantrieb und die Abbremsung des Ringes 2 erfolgt thermisch isoliert zum Ring 1. In der abgebremsten Stellung ist durch eine Balancierung der beiden Gasströme ein thermisch isolierter Stillstand erzielbar.

Als Material für den drehangetriebenen Ring 2 kommt bevorzugt ein solchen in Betracht, welches eine gering Wärmeabsorption besitzt. Insbesondere wird ein solches Material verwendet, welches eine geringe Infrarot-Absorption besitzt.

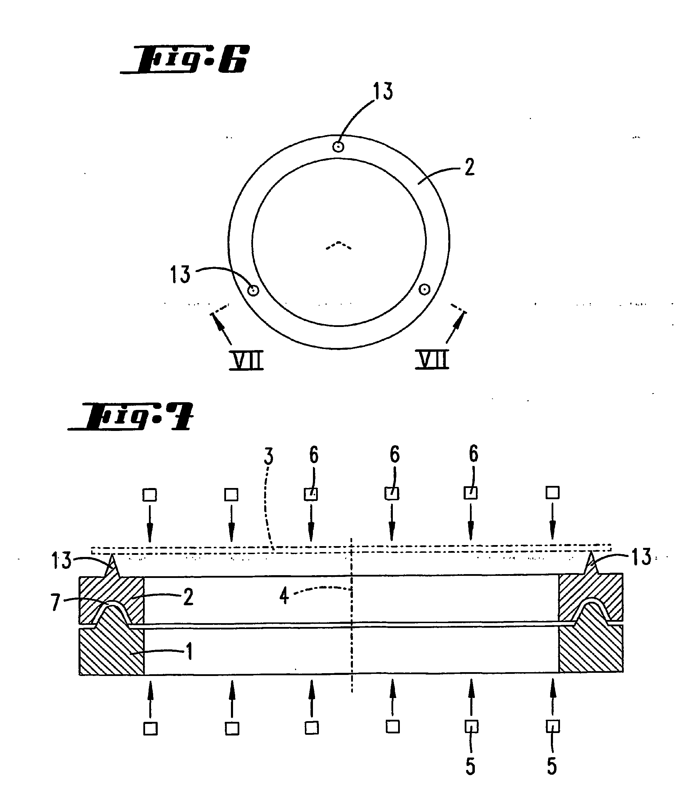

In der in den Figuren 6 und 7 dargestellten Variante liegt das Substrat 3 lediglich auf drei nadelförmigen Fortsätzen 13 auf, die dem drehangetriebenen Ring 2 zugeordnet sind. Dadurch ist der Flächenkontakt zwischen Substrat 3 und drehangetriebenen Ring 2 minimiert. Dies führt zu einer weiteren Verbesserung der thermisch isolierten Lagerung des Substrates 3.

## Patentansprüche

1. Aus einem Tragkörper (1) und darauf gelagerten und drehangetriebenen Substrathalter (2) bestehende Anordnung, wobei die Gaslagerung und der Drehantrieb mittels in die Trennfuge (7) zwischen Tragkörper (1) und Substrat (2) aus Düsen (11, 12) einströmendes Gas gebildet sind, **dadurch gekennzeichnet, dass** der Tragkörper (1) und der Substrathalter (2) als Ringe ausgebildet sind.

2. Anordnung nach Anspruch 1 oder insbesondere danach, **dadurch gekennzeichnet, dass** die Ringe selbst zentrierend aufeinanderliegen.

3. Anordnung nach einem oder mehreren der vorhergehenden Ansprüche oder insbesondere danach, **dadurch gekennzeichnet, dass** einer der Ringe (1) einen in eine Ringaussparung des anderen Ringes (2) ragenden Ringwulst aufweist.

4. Anordnung nach einem oder mehreren der vorhergehenden Ansprüche oder insbesondere danach, **dadurch gekennzeichnet, dass** das Substrat nur mit dem Rand auf dem drehangetriebenen Ring (2) gelagert ist.

5. Anordnung nach einem oder mehreren der vorhergehenden Ansprüche oder insbesondere danach, **dadurch gekennzeichnet, dass** das Substrat mit minimalem Kontakt, bevorzugt lediglich auf den Spitzen von nadelförmigen Vorsprüngen (13) auf dem Ring (2) aufliegt.

6. Anordnung nach einem oder mehreren der vorhergehenden Ansprüche oder insbesondere danach, **dadurch gekennzeichnet, dass** die Düsen (11, 12) in Nuten, insbesondere Bogennuten (10, 12) münden.

7. Anordnung nach einem oder mehreren der vorhergehenden Ansprüche oder insbesondere danach, **dadurch gekennzeichnet, dass** sich Bogennuten mit entgegengesetzt darin strömenden Gasströmen abwechseln.

8. Anordnung nach einem oder mehreren der vorhergehenden Ansprüche oder insbesondere danach, **gekennzeichnet durch** entgegengesetzt gerichtete Antriebsgasströme zum Drehlagern und Drehantreiben des rotierenden Ringes (1).

9. Anordnung nach einem oder mehreren der vorhergehenden Ansprüche oder insbesondere danach, **dadurch gekennzeichnet, dass** das Substrat (3) von unten durch die Ringe (1, 2). strahlungsbeheizbar ist.

10. Anordnung nach einem oder mehreren der vorhergehenden Ansprüche oder insbesondere danach, **dadurch gekennzeichnet, dass** der Tragkörper (1) und/oder der Substrathalter aus Quarz oder Keramikmaterial bestehen.

11. Anordnung nach einem oder mehreren der vorhergehenden Ansprüche oder insbesondere danach, **dadurch gekennzeichnet, dass** der drehangetriebene Ring (2) eine geringe Wärmeabsorption besitzt.

12. Anordnung nach einem oder mehreren der vorhergehenden Ansprüche oder insbesondere danach, **dadurch gekennzeichnet, dass** die Anordnung Teil einer Vorrichtung zum thermischen Behandeln von Halbleiterschichten ist.

13. Vorrichtung zum insbesondere kurzzeitigen thermischen Behandeln von insbesondere flachen Gegenständen, wie Halbleiter, Glas oder Metallsubstraten, mit einem Tragkörper (1) und einem davon drehantreibbar getragenem Substrathalter (2), auf welchem der flache Gegenstand (3) auflegbar ist, wobei mittels aus in eine Trennfuge (7) zwischen Tragkörper (1) und Haltekörper (2) mündenden Düsen tretendem Gas ein Gaspolster unter dem Substrathalter herstellbar ist, auf welchem der Substrathalter (2) von gerichteten Gasströmen drehangetrieben aufliegt, **dadurch gekennzeichnet, dass** der Tragkörper (1) und der Substrathalter (2) als Ringe und die Vorrichtung insbesondere gemäß einem oder mehreren der vorhergehenden Ansprüche ausgebildet ist.

## Claims

1. Arrangement comprising a support body (1) and a substrate holder (2) which is supported thereon and driven in rotation, the gas bearing and the rotary drive being formed by means of gas flowing into the separating gap (7) between support body (1) and substrate (2) from nozzles (11, 12), **characterized in that** the support body (1) and the substrate holder (2) are formed as rings.

2. Arrangement according to Claim 1 or in particular according thereto, **characterized in that** the rings rest on top of one another in a self-centering fashion.

3. Arrangement according to one or more of the preceding claims or in particular according thereto, **characterized in that** one of the rings (1) includes a ring bead which projects into a ring recess in the other ring (2).

4. Arrangement according to one or more of the preceding claims or in particular according thereto, **characterized in that** the substrate is supported on the ring (2) which is driven in rotation only by means of its edge.

5. Arrangement according to one or more of the preceding claims or in particular according thereto, **characterized in that** the substrate rests on the ring (2) with minimal contact, preferably only on the tips of needle-like protuberances (13).

6. Arrangement according to one or more of the preceding claims or in particular according thereto, **characterized in that** the nozzles (11, 12) open out into grooves, in particular arcuate grooves (10, 12).

7. Arrangement according to one or more of the preceding claims or in particular according thereto, **characterized in that** arcuate grooves with gas streams flowing in opposite directions inside them alternate.

8. Arrangement according to one or more of the preceding claims or in particular according thereto, **characterized, by** oppositely directed driving gas streams for rotationally bearing and rotationally driving the rotating ring (1).

9. Arrangement according to one or more of the preceding claims or in particular according thereto, **characterized in that** the substrate (3) can be radiation-heated from below through the rings (1, 2).

10. Arrangement according to one or more of the preceding claims or in particular according thereto, **characterized in that** the support body (1) and/or the substrate holder consist of quartz or ceramic material.

11. Arrangement according to one or more of the preceding claims or in particular according thereto, **characterized in that** the rotationally driven ring (2) has a low heat absorption.

12. Arrangement according to one or more of the preceding claims or in particular according thereto, **characterized in that** the arrangement is part of a device for the heat treatment of semiconductor wafers.

13. Device for the in particular rapid heat treatment of in particular flat objects, such as semiconductors, glass or metal substrates, having a support body (1) and a substrate holder (2) which is supported thereby in such a manner that it can be driven in rotation and on which the flat object (3) can be placed, it being possible to produce a gas cushion beneath the substrate holder by means of gas which emerges from nozzles which open out into a separating gap (7) between support body (1) and holding body (2), on which gas cushion the substrate holder (2) rests in such a manner that it is driven in rotation by directed gas streams, **characterized in that** the support body (1) and the substrate holder (2) are formed as rings and the device is formed in particular according to one or more of the preceding claims.

## Revendications

1. Ensemble constitué d'un corps de support (1) sur lequel est monté un porte-substrat (2) entraîné en rotation, dans lequel le support par un palier à gaz et l'entraînement en rotation sont réalisés au moyen d'un gaz injecté par des buses (11, 12) dans la jonction de séparation (7) entre le corps de support (1) et le substrat (2), **caractérisé en ce que** le corps de support (1) et le porte-substrat (2) sont conformés en bagues.

2. Ensemble selon la revendication 1 ou en particulier selon celle-ci, **caractérisé en ce que** les bagues elles-mêmes sont placées l'une sur l'autre en étant centrées.

3. Ensemble selon l'une ou plusieurs des revendications précédentes ou en particulier selon celles-ci, **caractérisé en ce que** l'une des bagues (1) comporte un bourrelet annulaire saillant dans un évidement annulaire de l'autre bague (2).

4. Ensemble selon l'une ou plusieurs des revendications précédentes ou en particulier selon celles-ci, **caractérisé en ce que** le substrat n'est monté sur la bague (2) entraînée en rotation qu'au niveau du bord.

5. Ensemble selon l'une ou plusieurs des revendications précédentes ou en particulier selon celles-ci, **caractérisé en ce que** le substrat repose sur la bague (2) avec un contact minimum, de préférence seulement sur les sommets de saillies (13) en forme d'aiguilles.

6. Ensemble selon l'une ou plusieurs des revendications précédentes ou en particulier selon celles-ci, **caractérisé en ce que** les buses (11, 12) débouchent dans des rainures, notamment des rainures incurvées (10, 12).

7. Ensemble selon l'une ou plusieurs des revendications précédentes ou en particulier selon celles-ci, **caractérisé par** une alternance des gorges incurvées dans lesquelles des flux de gaz s'écoulent en sens opposé.

8. Ensemble selon l'une ou plusieurs des revendications précédentes ou en particulier selon celles-ci, **caractérisé par** des flux de gaz d'entraînement de direction opposée pour supporter en rotation et entraîner en rotation la bague rotative (1).

9. Ensemble selon l'une ou plusieurs des revendications précédentes ou en particulier selon celles-ci, **caractérisé en ce que** le substrat (3) peut être chauffé par rayonnement depuis le bas à travers les bagues (1, 2).

10. Ensemble selon l'une ou plusieurs des revendications précédentes ou en particulier selon celles-ci, **caractérisé en ce que** le corps de support (1) et/ou le porte-substrat sont en quartz ou en céramique.

11. Ensemble selon l'une ou plusieurs des revendications précédentes ou en particulier selon celles-ci, **caractérisé en ce que** la bague (2) entraînée en rotation a une faible capacité d'absorption de chaleur.

12. Ensemble selon l'une ou plusieurs des revendications précédentes ou en particulier selon celles-ci, **caractérisé en ce que** l'ensemble fait partie d'un dispositif de traitement thermique de couches semi-conductrices.

13. Dispositif de traitement thermique, notamment momentané, d'objets notamment plats, tels que des substrats à base de semi-conducteur, de verre ou de métal, ledit dispositif comportant un corps de support (1) et un porte-substrat (2) qui est supporté par ledit corps de support de manière à pouvoir être entraîné en rotation et sur lequel l'objet plat (3) peut être déposé, un coussin de gaz, sur lequel le porte-substrat (2) est placé pour être entraîné en rotation par des flux de gaz orienté, pouvant être généré au moyen d'un gaz sortant de buses qui débouchent dans une jonction de séparation (7) entre le corps de support et le corps de retenue (2), **caractérisé en ce que** le corps de support (1) et le porte-substrat (2) sont conformés en bagues et le dispositif est conformé notamment selon l'une ou plusieurs des revendications précédentes.
